# EUROPÄISCHE PATENTSCHRIFT

(11) **EP 0 750 792 B1**
(45) Veröffentlichungstag und Bekanntmachung des Hinweises auf die Patenterteilung: **12.08.1998**
(21) Anmeldenummer: 95910431.6
(22) Anmeldetag: 02.03.1995
(51) Int. Cl.: H01L 23/552, H01L 23/40, H05K 9/00

(54) **KÜHL- UND ABSCHIRMVORRICHTUNG FÜR EINE INTEGRIERTE SCHALTUNG**
COOLING AND SCREENING DEVICE FOR AN INTEGRATED CIRCUIT
DISPOSITIF DE REFROIDISSEMENT ET DE BLINDAGE POUR CIRCUITS INTEGRES

(30) Priorität: 14.03.1994 DE 9404266 U
(43) Veröffentlichungstag der Anmeldung: 02.01.1997
(73) Patentinhaber: Siemens Nixdorf Informationssysteme AG, 33106 Paderborn (DE)
(72) Erfinder: NEUMANN, Gerd, D-33106 Paderborn (DE); JOHN, Hans-Jörg, D-33100 Paderborn (DE); WEEGE, Horst, D-33106 Paderborn (DE)
(74) Vertreter: Epping, Wilhelm, Dr.-Ing.
(86) Internationale Anmeldenummer: DE9500273
(87) Internationale Veröffentlichungsnummer: WO9525347

(56) Entgegenhaltungen:
- EP-A- 0 127 115
- EP-A- 0 265 285
- EP-A- 0 340 959
- EP-A- 0 632 686
- US-A- 5 031 028
- US-A- 5 053 924
- PATENT ABSTRACTS OF JAPAN vol. 018 no. 643 (E-1640) ,7.Dezember 1994 & JP,A,06 252282 (NEC CORP) 9.September 1994,

## Beschreibung

Die Erfindung betrifft eine Kühl- und Abschirmvorrichtung für integrierte Schaltungen, insbesondere für VLSI-Chips nach dem Oberbegriff des Anspruchs 1. Eine solche Vorrichtung ist aus der EP-A-0 340 959 bekannt.

Chips der genannten Art enthalten hochintegrierte komplexe Schaltkreise, wie zum Beispiel komplette Prozessoren. Die elektrische Leistungsaufnahme dieser Schaltkreise ist so hoch, daß sie nicht ohne zusätzliche Kühlmaßnahmen betrieben werden können. Ein weiteres Problem ist darin zu sehen, daß die genannten Schaltkreise bei sehr hohen Taktfrequenzen betrieben werden, so daß von ihnen eine energiereiche elektromagnetische Störstrahlung ausgeht, welche abgeschirmt werden muß.

Es ist bereits bekannt, auf der Oberfläche des Schaltungsgehäuses einen Kühlkörper zu befestigen, dessen Oberseite mit Kühlrippen oder -zapfen versehen ist. Zur Erzielung einer Abschirmwirkung muß dieser Kühlkörper mit Massepotential verbunden werden. In Fig. 5 ist eine aus dem Stand der Technik bekannte Kühl- und Abschirmvorrichtung für eine auf einer Leiterplatte 1 angeordnete integrierte Schaltung 2 in perspektivischer Explosionsdarstellung gezeigt. Darin ist ein Kühlkörper 3 enthalten, der aus einer Metallplatte 4 besteht, auf deren Oberseite quaderförmige Kühlvorsprünge 5 in regelmäßigem gegenseitigem Abstand angeordnet sind. Mit seiner planen Unterseite 6 wird der Kühlkörper 3 auf die integrierte Schaltung aufgesetzt und mit einem Rahmen 8 unter Zwischenlage elektrisch nichtleitender Abstandshalter überdeckt. Durchbrüche 9 in dem Rahmen 8 gestatten den Durchtritt der Kühlvorsprünge 5 durch diesen.

Die integrierte Schaltung 2 ist von einem Federblechstreifen 10 umgeben, der an seiner Unterkante mit in regelmäßigem Abstand angeordneten Lötspießen 11 versehen ist. Diese sind in durchkontaktierte Bohrungen 12 in der Leiterplatte 1 eingesetzt und darin verlötet. An dem oberen Rand des Federblechstreifens 10 sind S-förmige Kontaktfedern 13 freigestanzt, die in zusammengebautem Zustand der Anordnung die Ränder 14 des Deckrahmens 8 umgreifen und eine elektrische Verbindung zwischen diesem und der Leiterplatte herstellen. Im allgemeinen wird diese Anordnung auf der Leiterplatte mit Massepotential verbunden. Eine ähnliche Anordnung, mit einer geschlossenen Deckplatte, die lediglich Abschirmzwecken dient, ist auch aus der EP-A-0 256 285 bekannt. In beiden Fällen wird die Abdeckung nur durch Federkraft gehalten. Eine gasdichte Verbindung zwischen dieser und den Kontaktfedern besteht nicht. Eine weitere ähnliche Anordnung ist aus dem Dokument EP-A- 0 632 686 bekannt, das eine Frühere europäische Anmeldung im Sinn von Artikel 54(3) EPÜ darstellt.

Die Kühlwirkung der in Fig. 5 dargestellten bekannten Anordnung ist so lange ausreichend, wie sich der Deckrahmen nicht durch Vibrationen aus den Federn löst. Darüber hinaus ergeben sich bisweilen auch Abschirmprobleme. Diese entstehen dadurch, daß der Rahmen 8 zwar zuverlässig auf Massepotential liegt, die Kühlvorsprünge 5 jedoch aus dem Deckrahmen herausragen und aufgrund ihrer Antennenwirkung (abhängig von der Länge der Kühlvorsprünge 5) Störstrahlung abgeben.

Der bekannte Kühlkörper 3 ist aus einem Strangpreßprofil mit in Längsrichtung auf der Oberseite ausgebildeten Rippen angefertigt. Zur Erzielung quaderförmiger Kühlvorsprünge werden in die Rippen Quernute gefräst. Dies bedingt einen zusätzlichen Arbeitsgang bei der Kühlkörper-Herstellung.

Es ist die Aufgabe der Erfindung eine Kühl- und Abschirmvorrichtung für integrierte Schaltungen anzugeben, die ein verbessertes Kühl- und Abschirmverhalten zeigt und weniger Teile aufweist.

Diese Aufgabe wird durch die in Anspruch 1 genannten Merkmale gelöst. Der Kühlkörper ist nahe seinen Seitenkanten von Durchbrüchen durchsetzt, die von dessen Unter- zu seiner Oberseite verlaufen. In diese sind Kontaktstifte mit ihrem einen Ende so eingesetzt, daß sie mit dem Kühlkörper einen zuverlässigen dauerhaften elektrischen Kontakt bilden. Sie stehen dabei senkrecht von der Unterseite des Kühlkörpers ab und können deshalb wie ein vielkontaktiges elektrisches Bauelement in durchkontaktierte Bohrungen auf der Leiterplatte eingesetzt und in diesen verlötet werden. Dadurch ergibt sich nicht nur eine zuverlässige elektrische, sondern auch mechanische Verbindung, so daß der Kühlkörper sich auch bei mechanischen Erschütterungen nicht von der integrierten Schaltung lösen kann.

Die Kühlwirkung des Kühlkörpers kann noch dadurch verbessert werden, daß dieser aus einem Aluminiumblock in Fließpreßtechnik hergestellt wird. Der Kühlkörper hat dann sofort seine endgültige Form, so daß eine Nachbearbeitung sich erübrigt. Ein weiterer Vorteil ist darin zu sehen, daß die Materialdichte an dem Übergang von dem flächigen Teil zu den Kühlvorsprüngen besonders hoch ist und die Materialflußrichtung sich in Richtung zu den Kühlvorsprüngen erstreckt. Hierdurch wird der Wärmefluß in die Kühlvorsprünge unterstützt. Bei diesem Herstellungsverfahren sind viele geometrische Formen der Kühlvorsprünge, insbesondere jedoch runde Formen herstellbar. Diese sind von einem Kühlluftstrom leichter als kantige Kühlvorsprünge zu umströmen.

Die zum Einsetzen in die Durchbrüche des Kühlkörpers bestimmten Enden der Kontaktstifte sind ösenförmig aufgeweitet und haben im Bereich der Ösen scharfe Kanten. Beim Einpressen der Kontaktstifte in die Durchbrüche des Kühlkörpers prägen sich die Kanten in das weichere Material des Kühlkörpers ein und bilden so eine gasdichte elektrische Verbindung zwischen dem Kühlkörper und den Kontaktstiften. Dies führt besonders dann zu einer festen und auf Dauer korrosionsfreien Verbindung, wenn die Kontaktstifte aus einer federharten Zinn-Bronze bestehen.

In einer Weiterbildung der Erfindung sind die Kontaktstifte in ihrem Mittenbereich durch einen Blechstreifen miteinander verbunden, an den sie einstückig angeformt sind. In einfacher Weise können so mehrere Kontaktstifte zusammen mit dem sie verbindenden Blechstreifen in einem Arbeitsgang durch Ausstanzen hergestellt werden.

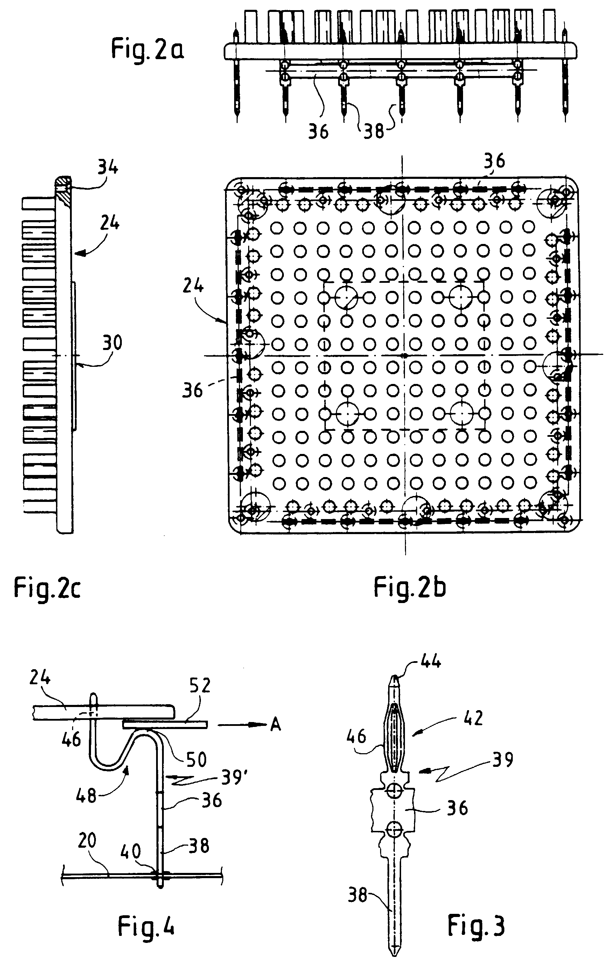

Bei einem in Fig. 4 gezeigten Ausführungsbeispiel der erfindungsgemäßen Vorrichtung ist das dem Kühlkörper nahe Ende der Kontaktstifte elastisch verformbar und S-förmig in Richtung des Kühlkörpers so weit zurückgebogen, daß der der Öse ferne S-Bogen den Kühlkörper berührt. Wird dieser federnde Bereich während des Einlötens der Kontaktstifte in die durchkontaktierten Bohrungen der elektrischen Leiterplatte unter Zugspannung gehalten, so preßt die Rückstellkraft der federnden Bereiche aller Kontaktstifte den Kühlkörper fest auf die integrierte Schaltung, wodurch der Wärmeübergang von dieser zu dem Kühlkörper noch weiter verbessert wird. Die Vorspannung des federnden Bereichs ist für alle Kontaktstifte besonders einfach und gleichmäßig dadurch einzustellen, daß zwischen den Kühlkörper und die ihn berührenden S-Bögen vor dem Einlöten ein Abstandshalter eingeschoben wird. Dieser wird nach dem Einlöten der Kontaktstifte wieder entfernt. Die Rückstellkraft der federnden Bereiche aller Kontaktstifte preßt den Kühlkörper dann besonders gleichmäßig auf die integrierte Schaltung, so daß ein Verkanten und damit ein verschlechterter Wärmeübergang ausgeschlossen ist.

Ausführungsbeispiele der Erfindung werden anhand der Figuren 1 bis 4 erläutert.

Es zeigt:
- Fig. 1: Eine perspektivische Draufsicht auf eine mit einer integrierten Schaltung bestückte Leiterplatte mit einer Kühl- und Abschirmvorrichtung in Explosionsdarstellung,
- Fig. 2: die Kühl- und Abschirmvorrichtung aus Fig. 1 in drei Ansichten,
- Fig. 3: ein erstes Ausführungsbeispiel eines Kontaktstiftes,
- Fig. 4: ein zweites Ausführungsbeispiel eines Kontaktstiftes.
- Fig. 5: zeigt eine Kühl- und Abschirmvorrichtung nach dem Stand der Technik.

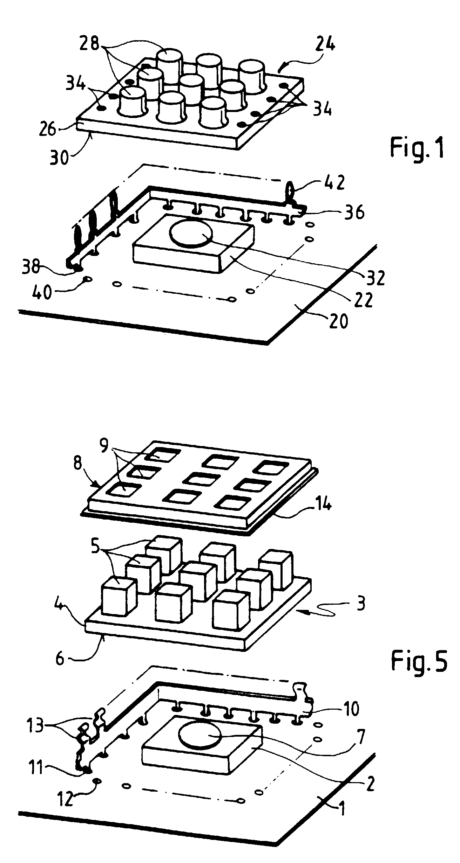

In Fig. 1 ist eine Leiterplatte 20 mit einem VLSI-Chip 22 dargestellt. Auf letzteren ist ein Kühlkörper 24 aufsetzbar, der aus einer Platte 26 besteht, an deren Oberseite zylinderförmige Kühlvorsprünge 28 einstückig angeformt sind. Die Unterseite 30 des Kühlkörpers 24 ist zumindest im Berührungsbereich mit dem Chip plan (Fig. 2c). Der Kühlkörper 24 ist mit seiner Unterseite 30 unter Zwischenlage einer elektrisch isolierenden Wärmeleitfolie 32 auf den Chip 22 aufsetzbar. Parallel zu ihren Rändern und mit geringem Abstand zu diesen ist die Platte 26 des Kühlkörpers 24 mit Durchbrüchen 34 durchsetzt, die die Platte in senkrechter Richtung durchdringen (Fig. 2b).

Blechstreifen 36 aus Zinn-Bronze sind im Abstand zu dem Chip 22 parallel zu dessen seitlichen Rändern angeordnet (in Fig. 1 nur teilweise dargestellt). Hierbei kann es sich um einen einzigen jeweils an den Ecken abgebogenen Blechstreifen wie in Fig. 1 oder um vier einzelne Blechstreifen wie in Fig. 2b handeln. An die eine Kante des Blechstreifens 36 sind in regelmäßigen Abständen Lötspieße 38 angeformt, die zum Einsetzen in durchkontaktierte Bohrungen 40 auf der Leiterplatte 20 und anschließendes Verlöten mit diesen bestimmt sind. Die durchkontaktierten Bohrungen sind untereinander und mit Massepotential durch nicht dargestellte Leiterbahnen verbunden.

An die andere Kante der Blechstreifen sind im Abstand der Durchbrüche 34 Einpreßstifte 42 einstückig angeformt, die an ihrem freien Ende in einer Spitze 44 auslaufen. Diese erleichtert das Einfädeln der Einpreßstifte 42 in die Durchbrüche 34. Ein Lötspieß 38 bildet mit dem ihm benachbarten Einpreßstift 42 jeweils einen Kontaktstift 39.

Wie besonders in Fig. 3 zu erkennen ist, sind die Einpreßstifte 42 in ihrem mittleren Bereich ähnlich einer Öse 46 aufgeweitet. Beim Einpressen der Einpreßstifte 42 in die Durchbrüche 34 prägen sich die Kanten der Ösen 46 in das weichere Material des Kühlkörpers 24 ein und bilden mit diesem einen innigen elektrischen und mechanischen Kontakt.

Fig. 2a zeigt den Kühlkörper 24 mit eingepreßten Kontaktstiften. Die Blechstreifen 36 kommen dabei senkrecht zu der Unterseite 30 des Kühlkörpers 24 zu liegen. Wird die Anordnung aus Kühlkörper 24 und Blechstreifen 36 nun, wie in Fig. 1 gezeigt, mit den Lötspießen 38 in die durchkontaktierten Bohrungen 40 der Leiterplatte 20 eingesetzt, so ist der Chip auf fünf Seiten von auf Massepotential liegenden Metallteilen eingeschlossen. Auf der Unterseite wird der Chip in bekannter Weise durch eine auf Massepotential liegende Lage der allgemein als Multilayer ausgebildeten Leiterplatte 20 abgeschirmt.

Fig. 4 zeigt ein zweites Ausführungsbeispiel des Kontaktstiftes 39' in Seitenansicht. Dieser entspricht in seinem Aufbau im wesentlichen dem in Fig. 3 dargestellten Ausführungsbeispiel. Zwischen dem Blechstreifen 36 und der Öse 46 ist jedoch ein elastisch verformbarer S-förmiger Federteil 48 so eingefügt, daß der der Öse 46 ferne S-Bogen 50 die Unterseite des Kühlkörpers 24 berührt.

Der Zusammenbau der Kühl- und Abschirmvorrichtung mit dem Chip 22 und der Leiterplatte 20 erfolgt in der Weise, daß vor dem Verlöten der Lötspieße 38 in den durchkontaktierten Bohrungen 40 zwischen dem Kühlkörper 24 und dem S-Bogen 50 ein Abstandshalter 52 eingeschoben wird. Nun werden die Lötspieße 38 in die durchkontaktierten Bohrungen 40 so eingesetzt, daß die Unterseite 30 des Kühlkörpers 24 vollflächig auf dem Chip 22 zu liegen kommt. Darauf werden die Lötspieße 38 mit den durchkontaktierten Bohrungen 40 verlötet. Anschließend wird der Abstandshalter 52 aus dem Spalt zwischen dem S-Bogen 50 und dem Kühlkörper 24 in Pfeilrichtung A herausgezogen. Die Rückstellkräfte der S-förmigen Federteile 48 aller Kontaktstifte 39' pressen dann den Kühlkörper 24 auf die Chip-Oberfläche, wodurch eine innige thermische Kopplung zwischen beiden sichergestellt wird.

## Patentansprüche

1. Kühl- und Abschirmvorrichtung für eine integrierte Schaltung, insbesondere einen VLSI-Chip, bestehend aus einem flächigen Kühlkörper (24) aus Metall mit einer planen, zur Auflage auf dem Chip (22) bestimmten Unterseite (30) und einer mit Kühlvorsprüngen (28) ausgestatteten Oberseite, der entlang und nahe seinen Seitenkanten von von der Unter- zur Oberseite verlaufenden Durchbrüchen (34) durchsetzt ist, und Kontaktstiften (39, 39'), die mit ihrem einen Ende (42) unter Bildung einer elektrischen Verbindung in die Durchbrüche (34) des Kühlkörpers (24) so eingesetzt sind, daß sie senkrecht von dessen Unterseite (30) abstehen,
**dadurch gekennzeichnet,**
daß das zum Einsetzen in die Durchbrüche (34) des Kühlkörpers (24) bestimmte Ende der Kontaktstifte (39, 39') als Einpreßstift (42) ausgebildet ist, der ösenförmig aufgeweitet ist und zumindest im Bereich der ösenförmigen Aufweitung (46) scharfe Kanten hat,
daß im Bereich der Kanten eine gasdichte elektrische Verbindung zwischen dem Kühlkörper (24) und den in die Durchbrüche (34) eingesetzten Einpreßstiften (42) besteht,
und daß das jeweils andere Ende der Kontaktstifte (39, 39') als ein zum Einsetzen in durchkontaktierte Bohrungen (40) einer den Chip (22) tragenden elektrischen Leiterplatte (20) bestimmter Lötspieß (38) ausgebildet ist.

2. Vorrichtung nach Anspruch 1, bei der die Kühlvorsprünge senkrecht von der Oberseite abstehende Säulen (28) mit rundem oder auch anderem Querschnitt sind, dessen Ausdehnung in beiden Dimensionen der Ebene in etwa gleich ist.

3. Vorrichtung nach Anspruch 1 oder 2, bei der der Kühlkörper (24) aus fließgepreßtem Aluminium einstückig gebildet ist.

4. Vorrichtung nach einem der Ansprüche 1 bis 3, bei der die Kontaktstifte (39, 39') aus federharter Zinn-Bronze bestehen.

5. Vorrichtung nach einem der Ansprüche 1 bis 4, bei der mehrer Kontaktstifte (39, 39') in ihrem Mittelbereich durch einen Blechstreifen (36) miteinander verbunden sind, wobei die Kontaktstifte (39, 39') und der Blechstreifen (36) aus einem Stück bestehen.

6. Vorrichtung nach Anspruch 5, bei der das dem Kühlkörper (24) nahe Ende der Kontaktstifte (39') elastisch verformbar und S-förmig und in Richtung des Kühlkörpers (24) so weit zurückgebogen ist, daß der der ösenförmigen Aufweitung (46) ferne S-Bogen (50) den Kühlkörper berührt.

7. Vorrichtung nach Anspruch 6, bei der zwischen den Kühlkörper (24) und die ihn berührenden S-Bögen (50) ein Abstandshalter (52) eingeschoben ist, der nach dem Einsetzen der Lötspieße (38) der Kontaktstifte in die durchkontaktierten Bohrungen (40) der Leiterplatte (20) entfernbar ist.

## Claims

1. Cooling and screening device for an integrated circuit, in particular a VLSI chip, comprising a planar heat sink (24) made from metal and having a flat bottom side (30), which is intended for placing on the chip (22), and an upper side which is fitted with cooling projections (28) and is covered along and near its side edges by cut-outs (34) extending from the bottom side to the upper side, and contact pins (39, 39') which are inserted with one of their ends (42) into the cut-outs (34) of the heat sink (24) to form an electrical connection, in such a way that they project perpendicularly from the bottom side (30) of said heat sink, characterized in that the end of the contact pins (39, 39') which is intended for insertion into the cut-outs (34) of the heat sink (24) is constructed as a press-fit pin (42) which is widened in the shape of an eye and, at least in the region of the eye-shaped widening (46), has sharp edges,
in that in the region of the edges there is a gastight electrical connection between the heat sink (24) and the press-fit pins (42) inserted into the cut-outs (34), and in that the respective other end of the contact pins (39, 39') is constructed as a soldering tip (38) intended for insertion into plated-through bores (40) of an electric printed circuit board (20) carrying the chip (22).

2. Device according to Claim 1, in which the cooling projections are columns (28) which project perpendicularly from the upper side and have a round, or else other cross section, whose extent is approximately the same in the two dimensions of the plane.

3. Device according to Claim 1 or 2, in which the heat sink (24) is formed in one piece from impact-extruded aluminium.

4. Device according to one of Claims 1 to 3, in which the contact pins (39, 39') consist of spring-tempered tin bronze.

5. Device according to one of Claims 1 to 4, in which a plurality of contact pins (39, 39') are connected to one another in their middle region by a sheet-metal strip (36), the contact pins (39, 39') and the sheet-metal strip (36) comprising one piece.

6. Device according to Claim 5, in which the end of the contact pins (39') which is near the heat sink (24) is elastically deformable and in the shape of an S and is bent back so far in the direction of the heat sink (24) that the S bend (50) remote from the eye-shaped widening (46) touches the heat sink.

7. Device according to Claim 6, in which there is inserted between the heat sink (24) and the S bends (50) touching it a spacer (52) which can be removed after the insertion of the soldering tips (38) of the contact pins into the plated-through bores (40) of the printed circuit board (20).

## Revendications

1. Dispositif de refroidissement et de blindage d'un circuit intégré, notamment d'une puce VLSI, constitué d'un dissipateur (24) de chaleur plat, en métal, comportant une face (30) inférieure plane, prévue pour être placée sur la puce (22), et une face supérieure, qui est munie de parties (28) en saillie de refroidissement et qui est traversée le long et à proximité de ses arêtes latérales par des passages (34) s'étendant de la face inférieure à la face supérieure, et des broches (39,39') de contact qui, par l'une de leurs extrémités (42) sont, en formant une liaison électrique, introduites dans les passages (34) du dissipateur (24) de chaleur de manière à faire saillie perpendiculairement de la face (30) inférieure du dissipateur de chaleur, caractérisé en ce que l'extrémité des broches (39,39') de contact prévue pour être introduite dans les passages (34) du dissipateur (24) de chaleur est réalisée en broche (42) à enfoncer, qui est élargie en forme d'oeillet et qui a, au moins dans la zone de l'élargissement (46) en forme d'oeillet, des arêtes vives, en ce qu'il y a, dans la zone des arêtes, une liaison électrique étanche au gaz entre le dissipateur (24) de chaleur et les broches (42) à enfoncer introduites dans les passages (34) et en ce que l'autre extrémité des broches (39,39') de contact est réalisée en pointe (38) de brasage prévue pour être introduite dans des perçages (40) d'interconnexion d'une plaquette (20) électrique à circuit imprimé portant la puce (22).

2. Dispositif suivant la revendication 1, dans lequel les parties en saille de refroidissement sont des colonnes (28) qui font saillie perpendiculairement de la face supérieure, qui sont de section transversale circulaire ou aussi autre et dont l'étendue est à-peu-prés la même dans les deux dimensions du plan.

3. Dispositif suivant la revendication 1 ou 2, dans lequel le dissipateur (24) de chaleur est réalisé d'une seule pièce en aluminium extrudé.

4. Dispositif suivant l'une des revendications 1 à 3, dans lequel les broches (39,39') de contact sont en étain-bronze écroui.

5. Dispositif suivant l'une des revendications 1 à 4, dans lequel plusieurs broches (39,39') de contact sont reliées l'une à l'autre dans leur partie médiane par une bande (36) de tôle, les broches (39,39') de contact et la bande (36) de tôle étant d'une seule pièce.

6. Dispositif suivant la revendication 5, dans lequel l'extrémité des broches (39') de contact proche du dissipateur (24) de chaleur est déformable élastiquement, est en forme de S et est recourbée en direction du dissipateur (24) de chaleur jusqu'à ce que l'arc (50) du S éloigné de l'élargissement (46) en forme d'oeillet touche le dissipateur de chaleur.

7. Dispositif suivant la revendication 6, dans lequel il est enfilé entre le dissipateur (24) de chaleur et les arcs (50) en S qui le touchent, une entretoise (52) qui peut être retirée après l'introduction des pointes (38) de brasage des broches de contact dans les perçages (40) d'interconnexion de la plaquette (20) à circuit imprimé.
